# EUROPEAN PATENT APPLICATION

(11) **EP 4 358 159 A1**
(43) Date of publication of application: **24.04.2024**
(21) Application number: 22923528.8
(22) Date of filing: 14.12.2022
(51) Int. Cl.: H01L 31/18

(54) **CELL PRODUCTION SYSTEM AND CELL PRODUCTION METHOD**

(30) Priority: 29.01.2022 CN 202210111327
(71) Applicant: Contemporary Amperex Technology Co., Limited, Ningde City, Fujian 352100 (CN)
(72) Inventor: LIU, Zhaohui, NINGDE CITY, Fujian 352100 (CN); WANG, Yanfen, NINGDE CITY, Fujian 352100 (CN); CHEN, Changsong, NINGDE CITY, Fujian 352100 (CN); SU, Shuojian, NINGDE CITY, Fujian 352100 (CN); WANG, Yandong, NINGDE CITY, Fujian 352100 (CN); CHEN, Guodong, NINGDE CITY, Fujian 352100 (CN); GUO, Yongsheng, NINGDE CITY, Fujian 352100 (CN)
(74) Representative: Thoma, Michael
(86) International application number: PCT/CN2022/138918
(87) International publication number: WO 2023/142741

(57) **Abstract**

Embodiments of the present application provide a battery production system and a battery production method. The battery production system includes: a preheating apparatus, including preheating cavities, a first delivery mechanism being arranged in the preheating cavity, and the preheating cavity having a first charging door and a first discharging door; and a baking apparatus, including baking cavities, the baking cavity having a second charging door and a second discharging door, wherein the first delivery mechanism is configured to deliver the battery piece in the preheating cavity to the baking cavity through the first discharging door and the second charging door when the first discharging door and the second charging door are opposite and are both opened. The battery piece can be delivered from the preheating cavity to the baking cavity through the first delivery mechanism arranged in the preheating cavity in a short time, thus reducing the temperature drop of the battery piece during the delivery process, and avoiding the impact of the temperature drop on the process performance. Moreover, the delivery time of the battery piece is short, so the opening time of a cavity door can be shortened, the electric energy loss can be reduced, the delivery efficiency is high, and the production rhythm can be increased.

## Description

### Cross-Reference to Related Applications

The present application claims priority to Chinese patent application 202210111327.0 entitled "BATTERY PRODUCTION SYSTEM AND BATTERY PRODUCTION METHOD" and filed on January 29, 2022, the entire contents of which are incorporated herein by reference.

### Technical Field

The present application relates to the technical field of batteries, and in particular, to a battery production system and a battery production method.

### Background

In some related technologies, a double-glass photovoltaic assembly includes a composite layer composed of two pieces of glass and a solar battery piece. During the production process of the photovoltaic assembly, baking and other processes are required for the battery piece. During the process of baking the battery piece, there is a situation of cooling of the battery piece, so the process stability is difficult to ensure, and the operation efficiency is low.

### Summary of the Invention

Some embodiments of the present application provide a battery production system and a battery production method to alleviate the problem that the process stability is difficult to ensure.

Some embodiments of the present application provide a battery production system, including: a preheating apparatus, including preheating cavities, a first delivery mechanism being arranged in the preheating cavity, and the preheating cavity having a first charging door and a first discharging door; and a baking apparatus, including baking cavities, the baking cavity having a second charging door and a second discharging door, where the first delivery mechanism is configured to deliver the battery piece in the preheating cavity to the baking cavity through the first discharging door and the second charging door when the first discharging door and the second charging door are opposite and are both opened.

The battery piece can be delivered from the preheating cavity to the baking cavity through the first delivery mechanism arranged in the preheating cavity in a short time, thus reducing the temperature drop of the battery piece during the delivery process, and avoiding the impact of the temperature drop on the process performance. Moreover, the delivery time of the battery piece is short, so the opening time of a cavity door can be shortened, the electric energy loss can be reduced, the delivery efficiency is high, and the production rhythm can be increased. Furthermore, the first delivery mechanism is arranged in the preheating cavity, thus reducing the floor area, reducing the failure rate of the device, and increasing the reliability of the device.

In some embodiments, at least two baking cavities are provided, and the at least two baking cavities are arranged one above the other in sequence; and the battery production system further includes a first power mechanism in driving connection with the preheating apparatus, and the first power mechanism is configured to drive the preheating apparatus to move up and down so that the preheating cavity is located at the same height as one of the at least two baking cavities.

During the process that the first power mechanism drives the preheating apparatus to move up and down so that the preheating cavity is located at the same height as one of the at least two baking cavities, and the battery piece is delivered from the preheating cavity to the one of the baking cavities, the other baking cavities of the at least two baking cavities still perform the baking work, and the temperatures in the other baking cavities are not affected, thus increasing the baking efficiency and meeting the production rhythm.

In some embodiments, at least two preheating cavities are provided, and the at least two preheating cavities are arranged one above the other in sequence; at least two baking cavities are provided, and the at least two baking cavities are arranged one above the other in sequence; and one of the at least two preheating cavities is configured to be located at the same height as one of the at least two baking cavities.

Battery pieces are delivered to multiple baking cavities through multiple preheating cavities, so the production efficiency is high, and the production rhythm is increased.

In some embodiments, the battery production system further includes a first power mechanism in driving connection with the preheating apparatus, and the first power mechanism is configured to drive the preheating apparatus to move up and down so that the preheating cavity at the uppermost layer of the at least two preheating cavities is selectively located at the same height as any of the at least two baking cavities.

The first power mechanism drives the preheating apparatus to move and can enable the preheating cavity at the uppermost layer of the preheating apparatus to be located at the same height as the baking cavity at the uppermost layer, battery pieces can be delivered from corresponding preheating cavities to all baking cavities, and the lifting height of the first power mechanism can not be excessively increased, thus ensuring the stability of the center of gravity of the first power mechanism.

In some embodiments, the number of the baking cavities is greater than the number of the preheating cavities, the battery production system further includes a first power mechanism in driving connection with the preheating apparatus, and the first power mechanism is configured to drive the preheating apparatus to move up and down so that the nth preheating cavity of the at least two preheating cavities is selectively located at the same height as one of the nth baking cavity and the baking cavity below the nth baking cavity of the at least two baking cavities, where n is an integer greater than 0 and is the nth one arranged from top to bottom.

The number of the preheating cavities is less than the number of the baking cavities, and each preheating cavity can continuously receive battery pieces for preheating. After preheating, the battery pieces can be delivered to the baking cavities, so the battery pieces can be continuously delivered to each baking cavity. Moreover, by cooperation of multiple preheating cavities, the preheated battery pieces can be quickly provided to multiple baking cavities, so the production efficiency is high, and the production rhythm is increased.

In some embodiments, the battery production system further includes a charging apparatus, the charging apparatus includes a first linear delivery mechanism, and the first linear delivery mechanism is configured to deliver the battery piece to the preheating cavity through the first discharging door when the preheating cavity is located at the same height as the first linear delivery mechanism and the first charging door is opened.

The battery piece can be quickly delivered to the preheating cavity in the linear delivery mode, thus shortening the opening time of the charging door of the preheating cavity, avoiding the excessive heat loss in the preheating cavity, and reducing the electric energy loss; and there is no need to provide a robotic arm to transfer the battery piece, thus saving the space.

In some embodiments, at least two preheating cavities are provided, and the at least two preheating cavities are arranged one above the other in sequence; and the battery production system further includes a first power mechanism in driving connection with the preheating apparatus, and the first power mechanism is configured to drive the preheating apparatus to move up and down so that one of the at least two preheating cavities is located at the same height as the first linear delivery mechanism.

Each preheating cavity can be located at the same height as the first linear delivery mechanism in turn to receive battery pieces; after being preheated, the battery pieces are delivered to the baking cavity; and then, the first linear delivery mechanism continues to wait for receiving battery pieces, thus improving the smoothness of the workflow and avoiding the phenomenon of process disconnection.

In some embodiments, the battery production system further includes a cooling apparatus, the cooling apparatus includes cooling cavities, the cooling cavity has a third charging door and a third discharging door, a second delivery mechanism is arranged in the baking cavity, and the second delivery mechanism is configured to deliver the battery piece in the baking cavity to the cooling cavity through the second discharging door and the third charging door when the second discharging door and the third charging door are opposite and are both opened.

The battery piece can be delivered from the baking cavity to the cooling cavity through the second delivery mechanism in the baking cavity in a short time, thus shortening the opening time of the discharging door of the baking cavity, and reducing the electric energy loss; and the delivery efficiency is high, and the production rhythm can be increased.

In some embodiments, at least two baking cavities are provided, and the at least two baking cavities are arranged one above the other in sequence; and the battery production system further includes a second power mechanism in driving connection with the cooling apparatus, and the second power mechanism is configured to drive the cooling apparatus to move up and down so that the cooling cavity is located at the same height as one of the at least two baking cavities.

After the battery piece in one of the baking cavities is baked, the cooling cavity is located at the same height as the one of the baking cavities to cool the battery piece in the one of the baking cavities; and after the battery piece in another baking cavity is baked, the cooling cavity is located at the same height as the other baking cavity to cool the battery piece in the other baking cavity, thus increasing the production efficiency and meeting the production rhythm.

In some embodiments, at least two cooling cavities are provided, and the at least two cooling cavities are arranged one above the other in sequence; at least two baking cavities are provided, and the at least two baking cavities are arranged one above the other in sequence; and one of the at least two cooling cavities is configured to be located at the same height as one of the at least two baking cavities.

After the battery piece in one of the baking cavities is baked, one of the cooling cavities can be located at the same height as the one of the baking cavities to receive the battery piece in the one of the baking cavities for cooling; and after the battery piece in another baking cavity is baked, another cooling cavity can be located at the same height as the other baking cavity to receive the battery piece in the other baking cavity for cooling, thus increasing the production efficiency and meeting the production rhythm.

In some embodiments, the battery production system further includes a second power mechanism in driving connection with the cooling apparatus, and the second power mechanism is configured to drive the cooling apparatus to move up and down so that the cooling cavity at the uppermost layer of the at least two cooling cavities is selectively located at the same height as any of the at least two baking cavities.

The second power mechanism drives the cooling apparatus to move and can enable the cooling cavity at the uppermost layer of the cooling apparatus to be located at the same height as the baking cavity at the uppermost layer, battery pieces in all baking cavities can be received by corresponding cooling cavities, and the lifting height of the second power mechanism can not be excessively increased, thus ensuring the stability of the center of gravity of the second power mechanism.

In some embodiments, the number of the baking cavities is greater than the number of the cooling cavities, the battery production system further includes a second power mechanism in driving connection with the cooling apparatus, and the second power mechanism is configured to drive the cooling apparatus to move up and down so that the nth cooling cavity of the at least two cooling cavities is selectively located at the same height as one of the nth baking cavity and the baking cavity below the nth baking cavity of the at least two baking cavities, where n is an integer greater than 0 and is the nth one arranged from top to bottom.

The number of the cooling cavities is less than the number of the baking cavities, and each cooling cavity can continuously receive battery pieces for cooling. After cooling, the battery pieces can be delivered to the discharging apparatus hereinafter, and then, the battery pieces delivered by the baking cavities can be continuously received. By cooperation of multiple cooling cavities, the battery pieces baked by multiple baking cavities can be quickly cooled, so the production efficiency is high, and the production rhythm is increased.

In some embodiments, the battery production system further includes a discharging apparatus, a third delivery mechanism is arranged in the cooling cavity, and the third delivery mechanism is configured to deliver the battery piece in the cooling cavity to the discharging apparatus through the third discharging door when the third discharging door is located at the same height as the discharging apparatus and is opened.

The third delivery mechanism is arranged in the cooling cavity, thus reducing the floor area of the device, reducing the failure rate of the device, and increasing the reliability of the device.

In some embodiments, at least two cooling cavities are provided, and the at least two cooling cavities are arranged one above the other in sequence; and the battery production system further includes a second power mechanism in driving connection with the cooling apparatus, and the second power mechanism is configured to drive the cooling apparatus to move up and down so that one of the at least two cooling cavities is located at the same height as the discharging apparatus.

At least two cooling cavities are arranged one above the other in sequence, each cooling cavity can be located at the same height as the discharging apparatus under the drive of the second power mechanism, each cooling cavity can deliver the cooled battery pieces to the discharging apparatus in turn, and the discharging apparatus can continuously output the battery pieces, thus improving the smoothness of the workflow and avoiding the phenomenon of process disconnection.

Some embodiments of the present application further provide a battery production method, including the following steps: providing a battery production system, the battery production system including: a preheating apparatus, including preheating cavities, a first delivery mechanism being arranged in the preheating cavity, and the preheating cavity having a first charging door and a first discharging door; and a baking apparatus, including baking cavities, the baking cavity having a second charging door and a second discharging door; enabling the first discharging door and the second charging door to be opposite and be both opened; and delivering, by the first delivery mechanism, the battery piece in the preheating cavity to the baking cavity through the first discharging door and the second charging door.

The battery piece can be delivered from the preheating cavity to the baking cavity through the first delivery mechanism in the preheating cavity in a short time, thus reducing the temperature drop of the battery piece during the delivery process, and avoiding the impact of the temperature drop on the process performance. Moreover, the delivery time of the battery piece is short, so the opening time of a cavity door can be shortened, the electric energy loss can be reduced, the delivery efficiency is high, and the production rhythm can be increased. Furthermore, the first delivery mechanism is arranged in the preheating cavity, thus reducing the floor area of the device, reducing the failure rate of the device, and increasing the reliability of the device.

In some embodiments, at least two baking cavities are provided, and the at least two baking cavities are arranged one above the other in sequence. The step of enabling the first discharging door and the second charging door to be opposite and be both opened includes: driving, by the first power mechanism, the preheating apparatus to move up and down so that the preheating cavity is located at the same height as one of the at least two baking cavities, the first discharging door of the preheating cavity being opposite to the second discharging door of one of the baking cavities at this time; and controlling the first discharging door and the second discharging door to be opened.

During the process that the first power mechanism drives the preheating apparatus to move up and down so that the preheating cavity is located at the same height as one of the at least two baking cavities, and the battery piece is delivered from the preheating cavity to the one of the baking cavities, the other baking cavities of the at least two baking cavities still perform the baking work, and the temperatures in the other baking cavities are not affected, thus increasing the baking efficiency and meeting the production rhythm.

In some embodiments, the battery production system further includes a charging apparatus, and the charging apparatus includes a first linear delivery mechanism. At least two preheating cavities are provided, and the at least two preheating cavities are arranged one above the other in sequence. The battery production method further includes the following steps: driving, by the first power mechanism, the preheating apparatus to move up and down so that one of the at least two preheating cavities is located at the same height as the first linear delivery mechanism; enabling the first charging door to be opened; and delivering, by the first linear delivery mechanism, the battery piece to the preheating cavity through the first discharging door.

The battery piece can be quickly delivered to the preheating cavity in the linear delivery mode, thus shortening the opening time of the charging door of the preheating cavity, avoiding the excessive heat loss in the preheating cavity, and reducing the electric energy loss; and there is no need to provide a robotic arm to transfer the battery piece, thus saving the space.

In some embodiments, the battery production system further includes a cooling apparatus, the cooling apparatus includes cooling cavities, the cooling cavity has a third charging door and a third discharging door, and a second delivery mechanism is arranged in the baking cavity. The battery production method further includes the following steps: enabling the second discharging door and the third charging door to be opposite and be both opened; and delivering, by the second delivery mechanism, the battery piece in the baking cavity to the cooling cavity through the second discharging door and the third charging door.

The battery piece can be delivered from the baking cavity to the cooling cavity through the second delivery mechanism in the baking cavity in a short time, thus shortening the opening time of the discharging door of the baking cavity, and reducing the electric energy loss; and the delivery efficiency is high, and the production rhythm can be increased.

In some embodiments, at least two baking cavities are provided, and the at least two baking cavities are arranged one above the other in sequence. The step of enabling the second discharging door and the third charging door to be opposite and be both opened includes: driving, by the second power mechanism, the cooling apparatus to move up and down so that the cooling cavity is located at the same height as one of the at least two baking cavities, the third charging door of the cooling cavity being opposite to the second discharging door of one of the baking cavities at this time; and enabling the second discharging door and the third discharging door to be opened.

After the battery piece in one of the baking cavities is baked, the cooling cavity is located at the same height as the one of the baking cavities to cool the battery piece in the one of the baking cavities; and after the battery piece in another baking cavity is baked, the cooling cavity is located at the same height as the other baking cavity to cool the battery piece in the other baking cavity, thus increasing the production efficiency and meeting the production rhythm.

In some embodiments, the battery production system further includes a discharging apparatus. A third delivery mechanism is arranged in the cooling cavity, at least two cooling cavities are provided, and the at least two cooling cavities are arranged one above the other in sequence. The battery production method further includes the following steps: driving, by the second power mechanism, the cooling cavity apparatus to move up and down so that one of the at least two cooling cavities is located at the same height as the discharging apparatus; enabling the third discharging door to be opened; and delivering, by the third delivery mechanism, the battery piece to the discharging apparatus through the third discharging door.

The third delivery mechanism is arranged in the cooling cavity, thus reducing the floor area of the device, reducing the failure rate of the device, and increasing the reliability of the device.

Based on the above technical solutions, the present application has at least the following beneficial effects:
In some embodiments, the battery piece can be delivered from the preheating cavity to the baking cavity through the first delivery mechanism in the preheating cavity in a short time, thus reducing the temperature drop of the battery piece during the delivery process, and avoiding the impact of the temperature drop on the process performance. Moreover, the delivery time of the battery piece is short, so the opening time of a cavity door can be shortened, the electric energy loss can be reduced, the delivery efficiency is high, and the production rhythm can be increased.

### Description of Drawings

In order to illustrate the technical solutions in the embodiments of the present application more clearly, the following briefly introduces the drawings required in the embodiments of the present application. Obviously, the drawings described below are only some embodiments of the present application. For those of ordinary skill in the art, other drawings can also be obtained according to these drawings without any creative effort.
FIG. 1 is a schematic structural view of a double-glass photovoltaic assembly disclosed in some embodiments of the present application;
FIG. 2 is a schematic structural view of a battery production system disclosed in some embodiments of the present application.

In the drawings, the drawings are not drawn according to an actual scale.

Description of reference numerals: 1-preheating apparatus; 11-preheating cavity; 12-first delivery mechanism; 13-first charging door; 14-first discharging door; 2-baking apparatus; 21-baking cavity; 22-second delivery mechanism; 23-second charging door; 24-second discharging door; 3-cooling apparatus; 31-cooling cavity; 32-third delivery mechanism; 33-third charging door; 34-third discharging door; 4-charging apparatus; 41-first linear delivery mechanism; 5-discharging apparatus; 51-second linear delivery mechanism; 6-first power mechanism; 61-firstlead screw; 62-first guide rod; 7-second power mechanism; 71-second lead screw; 72-second guide rod.

### Detailed Description

The implementations of the present application are further described in detail below with reference to the drawings and embodiments. The following detailed description of the embodiments and the drawings are used to illustrate the principles of the present application by way of example, but should not be used to limit the scope of the present application, that is, the present application is not limited to the described embodiments.

In the description of the present application, it should be noted that unless otherwise stated, "multiple" means two or more; and the orientation or position relationships indicated by the terms "upper", "lower", "left", "right", "inner", "outer", and the like are only for facilitating the description of the present application and simplifying the description, rather than indicating or implying that the apparatus or element referred to must have a particular orientation or be constructed and operated in a particular orientation, and therefore will not be interpreted as limiting the present application. In addition, the terms "first", "second", "third", and the like are used for descriptive purposes only, and cannot be construed as indicating or implying relative importance. "Vertical" is not strictly vertical, but within an allowable range of an error. "Parallel" is not strictly parallel, but within an allowable range of an error.

The orientation words appearing in the following description are the directions shown in the figures, and do not limit the specific structure of the present application. In the description of the present application, it also should be noted that the terms "mounting", "connecting" and "connection" should be understood in a broad sense unless otherwise explicitly specified or defined. For example, the connection may be fixed connection, detachable connection, or integrated connection; and the connection may be direct connection, or indirect connection through an intermediate. For those of ordinary skill in the art, the specific meanings of the above terms in the present application may be understood according to specific circumstances.

The solar battery is a photoelectric semiconductor slice that directly generates power from sunlight, and is also known as a "solar chip" or a "photoelectric battery". When certain illumination conditions are met, the solar battery can output voltage and generate current when there is a loop.

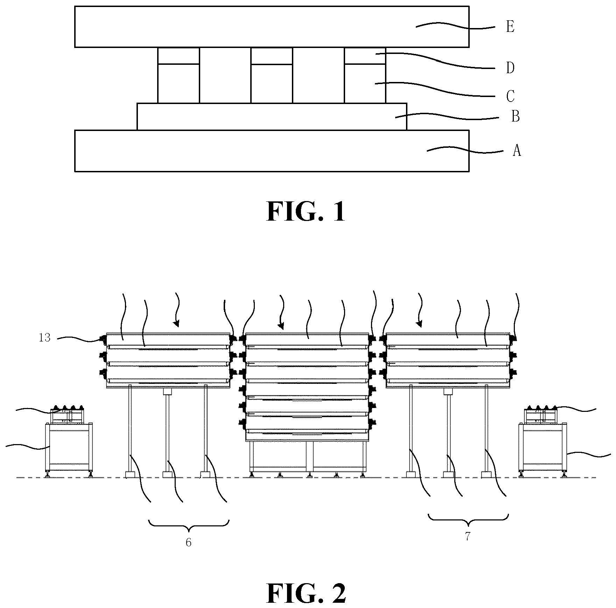

The solar battery includes a double-glass photovoltaic assembly. Referring to FIG. 1, the double-glass photovoltaic assembly includes a lower-layer glass sheet A, a front electrode layer B, a power generation layer C, a back electrode layer D, and an upper-layer glass sheet E, where the power generation layer C is made of a power generation material, the power generation material is coated on the glass sheet in the form of a solution to form a semi-finished battery piece (hereinafter referred to as a battery piece), and the battery piece needs to be baked and crystallized.

In some related technologies, methods for baking and crystallizing a battery piece include delivering the battery piece to a preheating region by a robotic arm for preheating, and after preheating, delivering the battery piece to a baking region by the robotic arm for baking.

The inventor found that using the robotic arm to deliver the battery piece takes a long delivery time. During the process of delivering the battery piece from the preheating region to the baking region, due to the long delivery time, the temperature of the preheated battery piece decreases. After the battery piece is delivered to the baking region, the temperature of the battery piece increases again. That is to say, the battery piece needs to undergo a cycle of heating, cooling and heating, which makes it hard to ensure process stability. Moreover, when the robotic arm picks up the material, the opening times of cavity doors of the preheating region and the baking region are long, which affects the temperature uniformity within the cavities and increases the power consumption. Furthermore, the robotic arm has a complex structure, occupies a large space, and has a high device failure rate. When there are many baking layers in the baking region, the robotic arm has a heavy load and low production efficiency and cannot meet the requirement for production rhythm. Moreover, using the robotic arm to deliver the battery piece also has the risk of breakage.

Based on this, embodiments of the present disclosure provide a battery production system and a battery production method for shortening the delivery time of battery pieces and reducing the impact of temperature drop on the process stability of batteries.

Referring to FIG. 2, in some embodiments, the battery production system includes a preheating apparatus 1 and a baking apparatus 2.

The preheating apparatus 1 includes preheating cavities 11, a first delivery mechanism 12 is arranged in the preheating cavity 11, and the preheating cavity 11 has a first charging door 13 and a first discharging door 14.

The baking apparatus 2 includes baking cavities 21, and the baking cavity 21 has a second charging door 23 and a second discharging door 24.

The first delivery mechanism 12 is configured to deliver the battery piece in the preheating cavity 11 to the baking cavity 21 through the first discharging door 14 and the second charging door 23 when the first discharging door 14 and the second charging door 23 are opposite and are both opened.

In the above embodiment, the first delivery mechanism 12 can deliver the battery piece in the preheating cavity 11 to the baking cavity 21 through the first discharging door 14 and the second charging door 23 when the first discharging door 14 and the second charging door 23 are opposite and are both opened, and the battery piece can be delivered from the preheating cavity 11 to the baking cavity 21 in a short time, thus reducing the temperature drop of the battery piece during the delivery process, and avoiding the impact of the temperature drop on the process performance. Moreover, the delivery time of the battery piece is short, so the opening time of a cavity door can be shortened, the electric energy loss can be reduced, the delivery efficiency is high, and the production rhythm can be increased. Furthermore, the first delivery mechanism 12 is arranged in the preheating cavity 11, thus reducing the floor area, reducing the failure rate of the device, and increasing the reliability of the device.

In some embodiments, at least two baking cavities 21 are provided, and the at least two baking cavities 21 are arranged one above the other in sequence; and the battery production system further includes a first power mechanism 6 in driving connection with the preheating apparatus 1, and the first power mechanism 6 is configured to drive the preheating apparatus 1 to move up and down so that the preheating cavity 11 is located at the same height as one of the at least two baking cavities 21.

The at least two baking cavities 21 are independent, and each baking cavity 21 has a second charging door 23 and a second discharging door 24. During the process that the first power mechanism 6 drives the preheating apparatus 1 to move up and down so that the preheating cavity 11 is located at the same height as one of the at least two baking cavities 21, and the battery piece is delivered from the preheating cavity 11 to the one of the baking cavities 21, the other baking cavities 21 of the at least two baking cavities 21 still perform the baking work, and the temperatures in the other baking cavities 21 are not affected, thus increasing the baking efficiency and meeting the production rhythm.

In some embodiments, the first power mechanism 6 includes a first motor, a first lead screw 61, a first nut, and first guide rods 62.

A first end of the first lead screw 61 is connected to the first motor, a second end of the first lead screw 61 is in threaded connection with the first nut, the first nut is fixedly arranged on the preheating apparatus 1, the first motor provides power to rotate the first lead screw 61, and the first lead screw 61 rotates to move the first nut up and down along the first lead screw, so as to drive the preheating apparatus 1 to move up and down.

Two first guide rods 62 are provided, the two first guide rods 62 are respectively arranged on both sides of the first lead screw 61, a first end of the first guide rod 62 is fixed, a second end of the first guide rod 62 is threaded in the preheating apparatus 1, the preheating apparatus 1 moves up and down along the first guide rod 62, and the preheating apparatus 1 is guided by the two first guide rods 62.

In some embodiments, at least two preheating cavities 11 are provided, and the at least two preheating cavities 11 are arranged one above the other in sequence; at least two baking cavities 21 are provided, and the at least two baking cavities 21 are arranged one above the other in sequence; and one of the at least two preheating cavities 11 is configured to be located at the same height as one of the at least two baking cavities 21.

At least two preheating cavities 11 are provided, and battery pieces can be placed in the at least two preheating cavities 11 for preheating. At least two baking cavities 21 are provided, and battery pieces can be placed in the at least two baking cavities 21 for baking. Since the preheating time in the preheating cavity 11 is shorter than the baking time in the baking cavity 21 and battery pieces can be placed in the at least two preheating cavities 11, after the battery piece in one of the preheating cavities 11 is preheated, the preheating cavity 11 is correspondingly located at the same height as one baking cavity 21, the first discharging door 14 of the preheating cavity 11 is opposite to the second charging door of the baking cavity 21, and the first delivery mechanism 12 delivers the battery piece in the preheating cavity 11 to the baking cavity 21 through the first discharging door 14 and the second charging door 23; and after the battery piece in another preheating cavity 11 is preheated, the other preheating cavity 11 is correspondingly located at the same height as another baking cavity 21, and the first delivery mechanism 12 in the other preheating cavity 11 delivers the battery piece in the other preheating cavity 11 to the other baking cavity 21. Battery pieces are delivered to multiple baking cavities 21 through multiple preheating cavities 11, so the production efficiency is high, and the production rhythm is increased.

In some embodiments, the battery production system further includes a first power mechanism 6 in driving connection with the preheating apparatus 1, and the first power mechanism 6 is configured to drive the preheating apparatus 1 to move up and down so that the preheating cavity 11 at the uppermost layer of the at least two preheating cavities 11 is selectively located at the same height as any of the at least two baking cavities 21.

The first power mechanism 6 drives the preheating apparatus 1 to move up and down so that the preheating cavity 11 at the uppermost layer of the at least two preheating cavities 11 is selectively located at the same height as any of the at least two baking cavities 21. The first power mechanism 6 drives the preheating apparatus 1 to move and can enable the preheating cavity 11 at the uppermost layer of the preheating apparatus 1 to be located at the same height as the baking cavity 21 at the uppermost layer, battery pieces can be delivered from corresponding preheating cavities 11 to all baking cavities 21, and the lifting height of the first power mechanism 6 can not be excessively increased, thus ensuring the stability of the center of gravity of the first power mechanism 6.

In some embodiments, the number of the baking cavities 21 is greater than the number of the preheating cavities 11, the battery production system further includes a first power mechanism 6 in driving connection with the preheating apparatus 1, and the first power mechanism 6 is configured to drive the preheating apparatus 1 to move up and down so that the nth preheating cavity 11 of the at least two preheating cavities 11 is selectively located at the same height as one of the nth baking cavity 21 and the baking cavity 21 below the nth baking cavity 21 of the at least two baking cavities 21, where n is an integer greater than 0 and is the nth one arranged from top to bottom.

For example, the first preheating cavity 11 is selectively located at the same height as one of the first baking cavity 21 and the baking cavity 21 below the first baking cavity 21, the second preheating cavity 11 is selectively located at the same height as one of the second baking cavity 21 and the baking cavity 21 below the second baking cavity 21, the third preheating cavity 11 is selectively located at the same height as one of the third baking cavity 21 and the baking cavity 21 below the third baking cavity 21, and so on.

The number of the preheating cavities 11 is less than the number of the baking cavities 21, and each preheating cavity 11 can continuously receive battery pieces for preheating. After preheating, the battery pieces can be delivered to the baking cavities 21. Since the preheating time of the preheating cavity 11 is less than the baking time of the baking cavity 21, after the battery pieces are preheated in each preheating cavity 11, the battery pieces are delivered to the baking cavities 21, and then, the next batch of battery pieces are preheated. As a result, the battery pieces can be continuously delivered to each baking cavity 21. Moreover, by cooperation of multiple preheating cavities 11, the preheated battery pieces can be quickly provided to multiple baking cavities 21, so the production efficiency is high, and the production rhythm is increased.

Optionally, the preheating time of the preheating cavity 11 is about 1 minute, and the baking time of the baking cavity 21 is about 10 minutes.

The preheating temperature in the preheating cavity 11 is lower than the baking temperature in the baking cavity 21. Optionally, the preheating temperature in the preheating cavity 11 is about 100°C, and the baking temperature in the baking cavity 21 is about 140°C.

In some embodiments, the first delivery mechanism 12 includes a linear delivery mechanism. Optionally, the first delivery mechanism 12 includes a delivery belt, a delivery chain, a delivery roller, a push rod, or the like.

In some embodiments, the battery production system further includes a charging apparatus 4, the charging apparatus 4 includes a first linear delivery mechanism 41, and the first linear delivery mechanism 41 is configured to deliver the battery piece to the preheating cavity 11 through the first discharging door 14 when the preheating cavity 11 is located at the same height as the first linear delivery mechanism 41 and the first charging door 13 is opened.

The first linear delivery mechanism 41 can deliver the battery piece to the preheating cavity 11 through the first discharging door 14 when the preheating cavity 11 is located at the same height as the first linear delivery mechanism 41 and the first charging door 13 is opened. The battery piece can be quickly delivered to the preheating cavity 11 in the linear delivery mode, thus shortening the opening time of the charging door of the preheating cavity 11, avoiding the excessive heat loss in the preheating cavity 11, and reducing the electric energy loss; and there is no need to provide a robotic arm to transfer the battery piece, thus saving the space, and reducing the breakage rate of the battery piece.

In some embodiments, at least two preheating cavities 11 are provided, and the at least two preheating cavities 11 are arranged one above the other in sequence; and the battery production system further includes a first power mechanism 6 in driving connection with the preheating apparatus 1, and the first power mechanism 6 is configured to drive the preheating apparatus 1 to move up and down so that one of the at least two preheating cavities 11 is located at the same height as the first linear delivery mechanism 41.

At least two preheating cavities 11 are arranged one above the other in sequence, and each preheating cavity 11 can be located at the same height as the first linear delivery mechanism 41 under the drive of the first power mechanism 6 to receive battery pieces, so the first linear delivery mechanism 41 can continuously deliver the battery pieces; each preheating cavity 11 can receive the battery pieces in turn; after being preheated, the battery pieces are delivered to the baking cavity 21; and then, the first linear delivery mechanism 41 continues to wait for receiving battery pieces, thus improving the smoothness of the workflow and avoiding the phenomenon of process disconnection.

Optionally, two, three or more preheating cavities 11 may be provided.

In a case that two preheating cavities 11 are provided, by reasonably setting the delivery time of the first linear delivery mechanism 41, the time for receiving the first linear delivery mechanism 41 by the preheating cavity 11, the preheating time of the preheating cavity 11, the time for delivering battery pieces from the preheating cavity 11 to the baking cavity 21, and the like, the two preheating cavities 11 can receive the battery pieces delivered by the first linear delivery mechanism 41 in turn and deliver the battery pieces to the baking cavity 21 in turn, thus meeting the production rhythm and increasing the production efficiency.

In a case that three preheating cavities 11 are provided, by reasonably setting the delivery time of the first linear delivery mechanism 41, the time for receiving the first linear delivery mechanism 41 by the preheating cavity 11, the preheating time of the preheating cavity 11, the time for delivering battery pieces from the preheating cavity 11 to the baking cavity 21, and the like, the three preheating cavities 11 can receive the battery pieces delivered by the first linear delivery mechanism 41 in turn and deliver the battery pieces to the baking cavity 21 in turn. Moreover, compared to the case of the two preheating cavities 11, after the preheating cavity 11 delivers the battery pieces to the baking cavity 21, there is a process of recovering the temperature in the preheating cavity 11, thus increasing the stability of the temperature in the preheating cavity 11.

The first linear delivery mechanism 41 includes a delivery belt, a delivery chain, a delivery roller, a push rod, or the like.

In some embodiments, the battery production system further includes a cooling apparatus 3, the cooling apparatus 3 includes cooling cavities 31, the cooling cavity 31 has a third charging door 33 and a third discharging door 34, and a second delivery mechanism 22 is arranged in the baking cavity 21.

The second delivery mechanism 22 is configured to deliver the battery piece in the baking cavity 21 to the cooling cavity 31 through the second discharging door 24 and the third charging door 33 when the second discharging door 24 and the third charging door 33 are opposite and are both opened.

The second delivery mechanism 22 can deliver the battery piece in the baking cavity 21 to the cooling cavity 31 through the second discharging door 24 and the third charging door 33 when the second discharging door 24 and the third charging door 33 are opposite and are both opened, and the battery piece can be delivered from the baking cavity 21 to the cooling cavity 31 in a short time, thus shortening the opening time of the discharging door of the baking cavity 21, and reducing the electric energy loss; and the delivery efficiency is high, and the production rhythm can be increased. The second delivery mechanism 22 is arranged in the baking cavity 21, thus reducing the floor area of the device, reducing the failure rate of the device, and increasing the reliability of the device.

The second delivery mechanism 22 is arranged in the baking cavity 21, and when the first delivery mechanism 12 in the preheating cavity 11 delivers the battery piece in the preheating cavity 11 to the baking cavity 21, the second delivery mechanism 22 can cooperate to receive the battery piece and quickly deliver the battery piece to the preset position in the baking cavity 21, thus further shortening the time for delivering the battery piece from the preheating cavity 11 to the baking cavity 21, avoiding the temperature drop of the battery piece during the delivery process, and reducing the impact of the temperature drop on the process performance.

In some embodiments, the second delivery mechanism 22 includes a linear delivery mechanism. Optionally, the second delivery mechanism 22 includes a delivery belt, a delivery chain, a delivery roller, a push rod, or the like.

In some embodiments, at least two baking cavities 21 are provided, and the at least two baking cavities 21 are arranged one above the other in sequence; and the battery production system further includes a second power mechanism 7 in driving connection with the cooling apparatus 3, and the second power mechanism 7 is configured to drive the cooling apparatus 3 to move up and down so that the cooling cavity 31 is located at the same height as one of the at least two baking cavities 21.

At least two baking cavities 21 are provided, so the baking efficiency of battery pieces can be increased. In different baking cavities 21, starting times for baking battery pieces are different, and baking completion times are also different. The second power mechanism 7 drives the cooling apparatus 3 to move up and down. After the battery piece in one of the baking cavities 21 is baked, the cooling cavity 31 is located at the same height as the one of the baking cavities 21 to cool the battery piece in the one of the baking cavities 21; and after the battery piece in another baking cavity 21 is baked, the cooling cavity 31 is located at the same height as the other baking cavity 21 to cool the battery piece in the other baking cavity 21, thus increasing the production efficiency and meeting the production rhythm.

Optionally, the cooling time in the cooling cavity 31 is about 1 minute, and the baking time in the baking cavity 21 is about 10 minutes. The baking temperature in the baking cavity 21 is about 140°C. The cooling temperature in the cooling cavity 31 is about 40°C.

In some embodiments, the second power mechanism 7 includes a second motor, a second lead screw 71, a second nut, and second guide rods 72.

A first end of the second lead screw 71 is connected to the second motor, a second end of the second lead screw 71 is in threaded connection with the second nut, the second nut is fixedly arranged on the cooling apparatus 3, the second motor provides power to enable the second lead screw 71 to rotate, and the second lead screw 71 rotates to enable the second nut to move up and down along the second lead screw, so as to drive the cooling apparatus 3 to move up and down.

Two second guide rods 72 are provided, the two second guide rods 72 are respectively arranged on both sides of the second lead screw 71, a first end of the second guide rod 72 is fixed, a second end of the second guide rod 72 is threaded in the cooling apparatus 3, the cooling apparatus 3 moves up and down along the second guide rod 72, and the cooling apparatus 3 is guided by the two second guide rods 72.

In some embodiments, at least two cooling cavities 31 are provided, and the at least two cooling cavities 31 are arranged one above the other in sequence; at least two baking cavities 21 are provided, and the at least two baking cavities 21 are arranged one above the other in sequence; and one of the at least two cooling cavities 31 is configured to be located at the same height as one of the at least two baking cavities 21.

At least two baking cavities 21 are provided. In different baking cavities 21, starting times for baking battery pieces are different, and baking completion times are also different. At least two cooling cavities 31 are provided. After the battery piece in one of the baking cavities 21 is baked, one of the cooling cavities 31 can be located at the same height as the one of the baking cavities 21 to receive the battery piece in the one of the baking cavities 21 for cooling; and after the battery piece in another baking cavity 21 is baked, another cooling cavity 31 can be located at the same height as the other baking cavity 21 to receive the battery piece in the other baking cavity 21 for cooling, thus increasing the production efficiency and meeting the production rhythm.

In some embodiments, the battery production system further includes a second power mechanism 7 in driving connection with the cooling apparatus 3, and the second power mechanism 7 is configured to drive the cooling apparatus 3 to move up and down so that the cooling cavity 31 at the uppermost layer of the at least two cooling cavities 31 is selectively located at the same height as any of the at least two baking cavities 21.

The second power mechanism 7 drives the cooling apparatus 3 to move up and down, so that the cooling cavity 31 at the uppermost layer of the at least two cooling cavities 31 is selectively located at the same height as any of the at least two baking cavities 21. The second power mechanism 7 drives the cooling apparatus 3 to move and can enable the cooling cavity 31 at the uppermost layer of the cooling apparatus 3 to be located at the same height as the baking cavity 21 at the uppermost layer, battery pieces in all baking cavities 21 can be received by corresponding cooling cavities 31, and the lifting height of the second power mechanism 7 can not be excessively increased, thus ensuring the stability of the center of gravity of the second power mechanism 7.

In some embodiments, the number of the baking cavities 21 is greater than the number of the cooling cavities 31, the battery production system further includes a second power mechanism 7 in driving connection with the cooling apparatus 3, and the second power mechanism 7 is configured to drive the cooling apparatus 3 to move up and down so that the nth cooling cavity 31 of the at least two cooling cavities 31 is selectively located at the same height as one of the nth baking cavity 21 and the baking cavity 21 below the nth baking cavity 21 of the at least two baking cavities 21, where n is an integer greater than 0 and is the nth one arranged from top to bottom.

For example, the first cooling cavity 31 is selectively located at the same height as one of the first baking cavity 21 and the baking cavity 21 below the first baking cavity 21, the second cooling cavity 31 is selectively located at the same height as one of the second baking cavity 21 and the baking cavity 21 below the second baking cavity 21, the third cooling cavity 31 is selectively located at the same height as one of the third baking cavity 21 and the baking cavity 21 below the third baking cavity 21, and so on.

The number of the cooling cavities 31 is less than the number of the baking cavities 21, and each cooling cavity 31 can continuously receive battery pieces for cooling. After cooling, the battery pieces can be delivered to the discharging apparatus 5 hereinafter. Since the cooling time of the cooling cavity 31 is less than the baking time of the baking cavity 21, after the battery pieces are cooled in each cooling cavity 31, the battery pieces are delivered to the discharging apparatus 5, and then, the next batch of battery pieces are cooled. As a result, the battery pieces delivered by each baking cavity 21 can be continuously received. By cooperation of multiple cooling cavities 31, the battery pieces baked by multiple baking cavities 21 can be quickly cooled, so the production efficiency is high, and the production rhythm is increased.

In some embodiments, the battery production system further includes a discharging apparatus 5, and a third delivery mechanism 32 is arranged in the cooling cavity 31.

The third delivery mechanism 32 is configured to deliver the battery piece in the cooling cavity 31 to the discharging apparatus 5 through the third discharging door 34 when the third discharging door 34 is located at the same height as the discharging apparatus 5 and is opened.

The third delivery mechanism 32 is arranged in the cooling cavity 31, thus reducing the floor area of the device, reducing the failure rate of the device, and increasing the reliability of the device.

The third delivery mechanism 32 is arranged in the cooling cavity 31, and when the second delivery mechanism 22 in the baking cavity 21 delivers the battery piece in the baking cavity 21 to the cooling cavity 31, the third delivery mechanism 32 can cooperate to receive the battery piece and quickly deliver the battery piece to the preset position in the cooling cavity 31, thus further shortening the time for delivering the battery piece from the baking cavity 21 to the cooling cavity 31, shortening the opening time of the discharging door of the baking cavity 21, and reducing the electric energy loss; and the delivery efficiency of the battery piece is high, and the production rhythm can be increased.

In some embodiments, the third delivery mechanism 32 includes a linear delivery mechanism. Optionally, the third delivery mechanism 32 includes a delivery belt, a delivery chain, a delivery roller, a push rod, or the like.

In some embodiments, at least two cooling cavities 31 are provided, and the at least two cooling cavities 31 are arranged one above the other in sequence; and the battery production system further includes a second power mechanism 7 in driving connection with the cooling apparatus 3, and the second power mechanism 7 is configured to drive the cooling apparatus 3 to move up and down so that one of the at least two cooling cavities 31 is located at the same height as the discharging apparatus 5.

At least two cooling cavities 31 are arranged one above the other in sequence, each cooling cavity 31 can be located at the same height as the discharging apparatus 5 under the drive of the second power mechanism 7, each cooling cavity 31 can deliver the cooled battery pieces to the discharging apparatus 5 in turn, and the discharging apparatus 5 can continuously output the battery pieces, thus improving the smoothness of the workflow and avoiding the phenomenon of process disconnection.

Optionally, two, three or more cooling cavities 31 may be provided.

Optionally, 16 to 24 baking cavities 21 are provided.

In some embodiments, the discharging apparatus 5 includes a second linear delivery mechanism 51. The second linear delivery mechanism 51 receives the battery piece delivered by the third delivery mechanism 32 in the cooling cavity 31, and there is no need to provide a robotic arm to transfer the battery piece, thus avoiding the space occupation. Moreover, the second linear delivery mechanism 51 cooperates with the third delivery mechanism 32, which can reduce the speed of outputting the battery piece from the cooling cavity 31 without affecting the return of the cooling cavity 31 to receive the battery piece baked by the baking cavity 21, thus increasing the production efficiency.

Optionally, the second linear delivery mechanism 51 includes a delivery belt, a delivery chain, a delivery roller, a push rod, or the like.

Some embodiments of the present disclosure further provide a battery production method, including the following steps:
a battery production system is provided, the battery production system including: a preheating apparatus 1, including preheating cavities 11, a first delivery mechanism 12 being arranged in the preheating cavity 11, and the preheating cavity 11 having a first charging door 13 and a first discharging door 14; and a baking apparatus 2, including baking cavities 21, the baking cavity 21 having a second charging door 23 and a second discharging door 24;
the first discharging door 14 and the second charging door 23 are enabled to be opposite and be both opened; and
the battery piece in the preheating cavity 11 is delivered, by the first delivery mechanism 12, to the baking cavity 21 through the first discharging door 14 and the second charging door 23.

In the above embodiment, the first delivery mechanism 12 can deliver the battery piece in the preheating cavity 11 to the baking cavity 21 through the first discharging door 14 and the second charging door 23 when the first discharging door 14 and the second charging door 23 are opposite and are both opened, and the battery piece can be delivered from the preheating cavity 11 to the baking cavity 21 in a short time, thus reducing the temperature drop of the battery piece during the delivery process, and avoiding the impact of the temperature drop on the process performance. Moreover, the delivery time of the battery piece is short, so the opening time of a cavity door can be shortened, the electric energy loss can be reduced, the delivery efficiency is high, and the production rhythm can be increased. Furthermore, the first delivery mechanism 12 is arranged in the preheating cavity 11, thus reducing the floor area of the device, reducing the failure rate of the device, and increasing the reliability of the device.

In some embodiments, at least two baking cavities 21 are provided, and the at least two baking cavities 21 are arranged one above the other in sequence.

The step of enabling the first discharging door 14 and the second charging door 23 to be opposite and be both opened includes:
the first power mechanism 6 drives the preheating apparatus 1 to move up and down so that the preheating cavity 11 is located at the same height as one of the at least two baking cavities 21, and the first discharging door 14 of the preheating cavity 11 is opposite to the second discharging door 24 of one of the baking cavities 21 at this time; and
the first discharging door 14 and the second discharging door 24 are controlled to be opened.

The at least two baking cavities 21 are independent, and each baking cavity 21 has a second charging door 23 and a second discharging door 24. During the process that the first power mechanism 6 drives the preheating apparatus 1 to move up and down so that the preheating cavity 11 is located at the same height as one of the at least two baking cavities 21, and the battery piece is delivered from the preheating cavity 11 to the one of the baking cavities 21, the other baking cavities 21 of the at least two baking cavities 21 still perform the baking work, and the temperatures in the other baking cavities 21 are not affected, thus increasing the baking efficiency and meeting the production rhythm.

In some embodiments, the battery production system further includes a charging apparatus 4, and the charging apparatus 4 includes a first linear delivery mechanism 41. At least two preheating cavities 11 are provided, and the at least two preheating cavities 11 are arranged one above the other in sequence.

The battery production method further includes the following steps:
the first power mechanism 6 drives the preheating apparatus 1 to move up and down so that one of the at least two preheating cavities 11 is located at the same height as the first linear delivery mechanism 41;
the first charging door 13 is enabled to be opened; and
the first linear delivery mechanism 41 delivers the battery piece to the preheating cavity 11 through the first discharging door 14.

The first linear delivery mechanism 41 can deliver the battery piece to the preheating cavity 11 through the first discharging door 14 when the preheating cavity 11 is located at the same height as the first linear delivery mechanism 41 and the first charging door 13 is opened. The battery piece can be quickly delivered to the preheating cavity 11 in the linear delivery mode, thus shortening the opening time of the charging door of the preheating cavity 11, avoiding the excessive heat loss in the preheating cavity 11, and reducing the electric energy loss; and there is no need to provide a robotic arm to transfer the battery piece, thus saving the space, and reducing the breakage rate of the battery piece.

In some embodiments, the battery production system further includes a cooling apparatus 3, the cooling apparatus 3 includes cooling cavities 31, the cooling cavity 31 has a third charging door 33 and a third discharging door 34, and a second delivery mechanism 22 is arranged in the baking cavity 21.

The battery production method further includes the following steps:
the second discharging door 24 and the third charging door 33 are enabled to be opposite and be both opened; and
the second delivery mechanism 22 delivers the battery piece in the baking cavity 21 to the cooling cavity 31 through the second discharging door 24 and the third charging door 33.

The second delivery mechanism 22 can deliver the battery piece in the baking cavity 21 to the cooling cavity 31 through the second discharging door 24 and the third charging door 33 when the second discharging door 24 and the third charging door 33 are opposite and are both opened, and the battery piece can be delivered from the baking cavity 21 to the cooling cavity 31 in a short time, thus shortening the opening time of the discharging door of the baking cavity 21, and reducing the electric energy loss; and the delivery efficiency is high, and the production rhythm can be increased. The second delivery mechanism 22 is arranged in the baking cavity 21, thus reducing the floor area of the device, reducing the failure rate of the device, and increasing the reliability of the device.

The second delivery mechanism 22 is arranged in the baking cavity 21, and when the first delivery mechanism 12 in the preheating cavity 11 delivers the battery piece in the preheating cavity 11 to the baking cavity 21, the second delivery mechanism 22 can cooperate to receive the battery piece and quickly deliver the battery piece to the preset position in the baking cavity 21, thus further shortening the time for delivering the battery piece from the preheating cavity 11 to the baking cavity 21, avoiding the temperature drop of the battery piece during the delivery process, and reducing the impact of the temperature drop on the process performance.

In some embodiments, at least two baking cavities 21 are provided, and the at least two baking cavities 21 are arranged one above the other in sequence.

The step of enabling the second discharging door 24 and the third charging door 33 to be opposite and be both opened includes:
the second power mechanism 7 drives the cooling apparatus 3 to move up and down so that the cooling cavity 31 is located at the same height as one of the at least two baking cavities 21, and the third charging door 33 of the cooling cavity 31 is opposite to the second discharging door 24 of one of the baking cavities 21 at this time; and
the second discharging door 24 and the third discharging door 34 are enabled to be opened.

At least two baking cavities 21 are provided, so the baking efficiency of battery pieces can be increased. In different baking cavities 21, starting times for baking battery pieces are different, and baking completion times are also different. The second power mechanism 7 drives the cooling apparatus 3 to move up and down. After the battery piece in one of the baking cavities 21 is baked, the cooling cavity 31 is located at the same height as the one of the baking cavities 21 to cool the battery piece in the one of the baking cavities 21; and after the battery piece in another baking cavity 21 is baked, the cooling cavity 31 is located at the same height as the other baking cavity 21 to cool the battery piece in the other baking cavity 21, thus increasing the production efficiency and meeting the production rhythm.

In some embodiments, the battery production system further includes a discharging apparatus 5. A third delivery mechanism 32 is arranged in the cooling cavity 31, at least two cooling cavities 31 are provided, and the at least two cooling cavities 31 are arranged one above the other in sequence.

The battery production method further includes the following steps:
the second power mechanism 7 drives the cooling cavity 31 to move up and down so that one of the at least two cooling cavities 31 is located at the same height as the discharging apparatus 5;
the third discharging door 34 is enabled to be opened; and
the third delivery mechanism 32 delivers the battery piece to the discharging apparatus 5 through the third discharging door 34.

The third delivery mechanism 32 is arranged in the cooling cavity 31, thus reducing the floor area of the device, reducing the failure rate of the device, and increasing the reliability of the device.

The third delivery mechanism 32 is arranged in the cooling cavity 31, and when the second delivery mechanism 22 in the baking cavity 21 delivers the battery piece in the baking cavity 21 to the cooling cavity 31, the third delivery mechanism 32 can cooperate to receive the battery piece and quickly deliver the battery piece to the preset position in the cooling cavity 31, thus further shortening the time for delivering the battery piece from the baking cavity 21 to the cooling cavity 31, shortening the opening time of the discharging door of the baking cavity 21, and reducing the electric energy loss; and the delivery efficiency is high, and the production rhythm can be increased.

Some specific embodiments of the production method of the battery production system are described below with reference to FIG. 2.

After the battery piece reaches the charging apparatus 4, the preheating apparatus 1 moves under the drive of the first power mechanism 6 to enable the first layer of preheating cavity 11 of the preheating apparatus 1 counted from top to bottom to decrease to the same height as the first linear delivery mechanism 41, the charging door of the first layer of preheating cavity 11 is opened, the battery piece enters the first layer of preheating cavity 11, the charging door of the first layer of preheating cavity 11 is closed, and the preheating apparatus 1 moves under the drive of the first power mechanism 6 to enable the second layer of preheating cavity 11 of the preheating apparatus 1 counted from top to bottom to be located at the same height as the first linear delivery mechanism 41, so as to wait for the next batch of battery pieces to enter.

When the battery piece in the preheating cavity 11 reaches the set preheating time, the preheating apparatus 1 moves under the drive of the first power mechanism 6 to enable the preheating cavity 11 to rise to the same height as the baking cavity 21 of the baking apparatus 2, the discharging door of the preheating cavity 11 is opened, the charging door of the baking cavity 21 is also opened, and the first delivery mechanism 12 starts to deliver the battery piece to the baking cavity 21.

When the battery piece in the baking cavity 21 reaches the set baking time, the second power mechanism 7 drives the cooling apparatus 3 to move to enable one of the cooling cavities 31 of the cooling apparatus 3 to rise to the same height as the baking cavity 21 in which the battery piece is waiting to be discharged, the discharging door of the baking cavity 21 and the charging door of the cooling cavity 31 are opened simultaneously, and the battery piece is delivered to the cooling cavity 31 through the second delivery mechanism 22.

When the battery piece in the cooling cavity 31 is cooled for the set time, the second power mechanism 7 drives the cooling apparatus 3 to move to enable the cooling cavity 31 to decrease to the same height as the second linear delivery mechanism 51 of the discharging apparatus 5, the discharging door of the cooling cavity 31 is opened, and the third delivery mechanism 32 delivers the battery piece to the second linear delivery mechanism 51, thus completing the crystallization process of the entire battery piece.

Although the present application has been described with reference to the preferred embodiments, various improvements may be made and components therein may be replaced with equivalents without departing from the scope of the present application. In particular, the technical features mentioned in the embodiments can be combined in any manner as long as there is no structural conflict. The present application is not limited to the specific embodiments disclosed herein, but rather includes all technical solutions falling within the scope of the claims.

## Claims

1. A battery production system, comprising:
a preheating apparatus (1), comprising preheating cavities (11), a first delivery mechanism (12) being arranged in the preheating cavity (11), and the preheating cavity (11) having a first charging door (13) and a first discharging door (14); and
a baking apparatus (2), comprising baking cavities (21), the baking cavity (21) having a second charging door (23) and a second discharging door (24);
wherein the first delivery mechanism (12) is configured to deliver a battery piece in the preheating cavity (11) to the baking cavity (21) through the first discharging door (14) and the second charging door (23) when the first discharging door (14) and the second charging door (23) are opposite and are both opened.

2. The battery production system according to claim 1, wherein at least two baking cavities (21) are provided, and the at least two baking cavities (21) are arranged one above the other in sequence; and the battery production system further comprises a first power mechanism (6) in driving connection with the preheating apparatus (1), and the first power mechanism (6) is configured to drive the preheating apparatus (1) to move up and down so that the preheating cavity (11) is located at the same height as one of the at least two baking cavities (21).

3. The battery production system according to claim 1 or 2, wherein at least two preheating cavities (11) are provided, and the at least two preheating cavities (11) are arranged one above the other in sequence; at least two baking cavities (21) are provided, and the at least two baking cavities (21) are arranged one above the other in sequence; and one of the at least two preheating cavities (11) is configured to be located at the same height as one of the at least two baking cavities (21).

4. The battery production system according to claim 3, wherein the battery production system further comprises a first power mechanism (6) in driving connection with the preheating apparatus (1), and the first power mechanism (6) is configured to drive the preheating apparatus (1) to move up and down so that the preheating cavity (11) at the uppermost layer of the at least two preheating cavities (11) is selectively located at the same height as any of the at least two baking cavities (21).

5. The battery production system according to claim 3 or 4, wherein the number of the baking cavities (21) is greater than the number of the preheating cavities (11), the battery production system further comprises a first power mechanism (6) in driving connection with the preheating apparatus (1), and the first power mechanism (6) is configured to drive the preheating apparatus (1) to move up and down so that the nth preheating cavity (11) of the at least two preheating cavities (11) is selectively located at the same height as one of the nth baking cavity (21) and the baking cavity (21) below the nth baking cavity (21) of the at least two baking cavities (21), wherein n is an integer greater than 0 and is the nth one arranged from top to bottom.

6. The battery production system according to any one of claims 1 to 5, further comprising a charging apparatus (4), wherein the charging apparatus (4) comprises a first linear delivery mechanism (41), and the first linear delivery mechanism (41) is configured to deliver the battery piece to the preheating cavity (11) through the first discharging door (14) when the preheating cavity (11) is located at the same height as the first linear delivery mechanism (41) and the first charging door (13) is opened.

7. The battery production system according to claim 6, wherein at least two preheating cavities (11) are provided, and the at least two preheating cavities (11) are arranged one above the other in sequence; and the battery production system further comprises a first power mechanism (6) in driving connection with the preheating apparatus (1), and the first power mechanism (6) is configured to drive the preheating apparatus (1) to move up and down so that one of the at least two preheating cavities (11) is located at the same height as the first linear delivery mechanism (41).

8. The battery production system according to any one of claims 1 to 7, further comprising a cooling apparatus (3), wherein the cooling apparatus (3) comprises cooling cavities (31), the cooling cavity (31) has a third charging door (33) and a third discharging door (34), a second delivery mechanism (22) is arranged in the baking cavity (21), and the second delivery mechanism (22) is configured to deliver the battery piece in the baking cavity (21) to the cooling cavity (31) through the second discharging door (24) and the third charging door (33) when the second discharging door (24) and the third charging door (33) are opposite and are both opened.

9. The battery production system according to claim 8, wherein at least two baking cavities (21) are provided, and the at least two baking cavities (21) are arranged one above the other in sequence; and the battery production system further comprises a second power mechanism (7) in driving connection with the cooling apparatus (3), and the second power mechanism (7) is configured to drive the cooling apparatus (3) to move up and down so that the cooling cavity (31) is located at the same height as one of the at least two baking cavities (21).

10. The battery production system according to claim 8 or 9, wherein at least two cooling cavities (31) are provided, and the at least two cooling cavities (31) are arranged one above the other in sequence; at least two baking cavities (21) are provided, and the at least two baking cavities (21) are arranged one above the other in sequence; and one of the at least two cooling cavities (31) is configured to be located at the same height as one of the at least two baking cavities (21).

11. The battery production system according to claim 10, wherein the battery production system further comprises a second power mechanism (7) in driving connection with the cooling apparatus (3), and the second power mechanism (7) is configured to drive the cooling apparatus (3) to move up and down so that the cooling cavity (31) at the uppermost layer of the at least two cooling cavities (31) is selectively located at the same height as any of the at least two baking cavities (21).

12. The battery production system according to claim 10 or 11, wherein the number of the baking cavities (21) is greater than the number of the cooling cavities (31), the battery production system further comprises a second power mechanism (7) in driving connection with the cooling apparatus (3), and the second power mechanism (7) is configured to drive the cooling apparatus (3) to move up and down so that the nth cooling cavity (31) of the at least two cooling cavities (31) is selectively located at the same height as one of the nth baking cavity (21) and the baking cavity (21) below the nth baking cavity (21) of the at least two baking cavities (21), wherein n is an integer greater than 0 and is the nth one arranged from top to bottom.

13. The battery production system according to any one of claims 8 to 12, further comprising a discharging apparatus (5), wherein a third delivery mechanism (32) is arranged in the cooling cavity (31), and the third delivery mechanism (32) is configured to deliver the battery piece in the cooling cavity (31) to the discharging apparatus (5) through the third discharging door (34) when the third discharging door (34) is located at the same height as the discharging apparatus (5) and is opened.

14. The battery production system according to claim 13, wherein at least two cooling cavities (31) are provided, and the at least two cooling cavities (31) are arranged one above the other in sequence; and the battery production system further comprises a second power mechanism (7) in driving connection with the cooling apparatus (3), and the second power mechanism (7) is configured to drive the cooling apparatus (3) to move up and down so that one of the at least two cooling cavities (31) is located at the same height as the discharging apparatus (5).

15. A battery production method, comprising the following steps:
providing a battery production system, the battery production system comprising: a preheating apparatus (1), comprising preheating cavities (11), a first delivery mechanism (12) being arranged in the preheating cavity (11), and the preheating cavity (11) having a first charging door (13) and a first discharging door (14); and a baking apparatus (2), comprising baking cavities (21), the baking cavity (21) having a second charging door (23) and a second discharging door (24);
enabling the first discharging door (14) and the second charging door (23) to be opposite and be both opened; and
delivering, by the first delivery mechanism (12), the battery piece in the preheating cavity (11) to the baking cavity (21) through the first discharging door (14) and the second charging door (23).

16. The battery production method according to claim 15, wherein at least two baking cavities (21) are provided, and the at least two baking cavities (21) are arranged one above the other in sequence;
the step of enabling the first discharging door (14) and the second charging door (23) to be opposite and be both opened comprises:
driving, by a first power mechanism (6), the preheating apparatus (1) to move up and down so that the preheating cavity (11) is located at the same height as one of the at least two baking cavities (21), the first discharging door (14) of the preheating cavity (11) being opposite to the second discharging door (24) of one of the baking cavities (21) at this time; and
controlling the first discharging door (14) and the second discharging door (24) to be opened.

17. The battery production method according to claim 15 or 16, wherein the battery production system further comprises a charging apparatus (4), and the charging apparatus (4) comprises a first linear delivery mechanism (41); at least two preheating cavities (11) are provided, and the at least two preheating cavities (11) are arranged one above the other in sequence;
the battery production method further comprises the following steps:
driving, by the first power mechanism (6), the preheating apparatus (1) to move up and down so that one of the at least two preheating cavities (11) is located at the same height as the first linear delivery mechanism (41);
enabling the first charging door (13) to be opened; and
delivering, by the first linear delivery mechanism (41), the battery piece to the preheating cavity (11) through the first discharging door (14).

18. The battery production system according to any one of claims 15 to 17, wherein the battery production system further comprises a cooling apparatus (3), the cooling apparatus (3) comprises cooling cavities (31), the cooling cavity (31) has a third charging door (33) and a third discharging door (34), and a second delivery mechanism (22) is arranged in the baking cavity (21);
the battery production method further comprises the following steps:
enabling the second discharging door (24) and the third charging door (33) to be opposite and be both opened; and
delivering, by the second delivery mechanism (22), the battery piece in the baking cavity (21) to the cooling cavity (31) through the second discharging door (24) and the third charging door (33).

19. The battery production system according to claim 18, wherein at least two baking cavities (21) are provided, and the at least two baking cavities (21) are arranged one above the other in sequence;
the step of enabling the second discharging door (24) and the third charging door (33) to be opposite and be both opened comprises:
driving, by the second power mechanism (7), the cooling apparatus (3) to move up and down so that the cooling cavity (31) is located at the same height as one of the at least two baking cavities (21), the third charging door (33) of the cooling cavity (31) being opposite to the second discharging door (24) of one of the baking cavities (21) at this time; and
enabling the second discharging door (24) and the third discharging door (34) to be opened.

20. The battery production system according to claim 18 or 19, wherein the battery production system further comprises a discharging apparatus (5); a third delivery mechanism (32) is arranged in the cooling cavity (31), at least two cooling cavities (31) are provided, and the at least two cooling cavities (31) are arranged one above the other in sequence;
the battery production method further comprises the following steps:
driving, by the second power mechanism (7), the cooling cavity (31) to move up and down so that one of the at least two cooling cavities (31) is located at the same height as the discharging apparatus (5);
enabling the third discharging door (34) to be opened; and
delivering, by the third delivery mechanism (32), the battery piece to the discharging apparatus (5) through the third discharging door (34).
